# EUROPÄISCHE PATENTANMELDUNG

(11) **EP 0 838 669 A2**
(43) Veröffentlichungstag der Anmeldung: **29.04.1998**
(21) Anmeldenummer: 97118251.4
(22) Anmeldetag: 21.10.1997
(51) Int. Cl.: G01H 3/00

(54) **Vorrichtung und Verfahren zur Bewertung der Geräusche von elektrischen Maschinen oder Geräten**

(30) Priorität: 22.10.1996 DE 19643476; 11.10.1997 DE 19745007
(71) Anmelder: ROBERT BOSCH GMBH, 70442 Stuttgart (DE)
(72) Erfinder: Simon, Clemens, 82319 Starnberg (DE); Syrop, Alan, Dr., CF5 2LD Cardiff (GB)

(57) **Zusammenfassung**

Es wird eine Vorrichtung und ein Verfahren zur Bewertung der Geräusche von elektrischen Maschinen oder Geräten und/oder deren stromdurchflossener Bauteile vorgeschlagen, mit wenigstens einer Spulenwicklung, in der ein magnetisches Wechselfeld auftritt, mit einer Aufnahmeeinrichtung (9, 10, 11) zur Detektion der Geräusche und mit Mitteln zur Verarbeitung der Signale der Aufnahmeeinrichtung. Für die Bestromung der Spulenwicklung (1, 2, 3) ist eine Wechselspannungsquelle (4) zur Erzeugung einer mechanischen Schwingung vorgesehen, mit der das Geräusch ausbildbar ist. Mittels der Frequenz der Wechselspannung ist das Geräusch im herkömmlichen stromführenden Betriebszustand nachbildbar. Außerdem läßt sich das vorgeschlagenen Verfahren zur Fertigungskontrolle und/oder Qualitätsprüfung der stromdurchflossenen Bauteile einsetzen, wobei das bei einer vorher festgelegten Frequenz der Wechselspannung auftretende Geräusch bewertet wird.

## Beschreibung

### Stand der Technik

Die Erfindung betrifft eine Vorrichtung und ein Verfahren zur Bewertung der Geräusche von elektrischen Maschinen oder Geräten und/oder deren stromdurchflossener Bauteile nach dem Oberbegriff des Anspruchs 1 bzw. des Anspruchs 10.

Die Bewertung der Betriebsgeräusche von elektrischen Maschinen oder Geraten, die über wenigstens eine Spulenwicklung verfügen und im herkömmlichen stromführenden Betriebszustand ein magnetisches Wechselfeld aufweisen, ist vor allem unter dem Gesichtspunkt der Geräuschminimierung bei der Entwicklung derartiger Maschinen und Geräte bzw. bei der optimalen Komponentenauswahl von Interesse. Unter Spulenwicklung soll im folgenden eine Anordnung elektrischer Leiter in beispielsweise elektrischen Maschinen, Transformatoren, Elektromagneten oder dergleichen verstanden werden.

Bei einer bekannten Ausführungsform werden z. B. die Betriebsgeräusche einer Lichtmaschine für ein Kraftfahrzeug bewertet. Dieser elektrische Generator, meist in Form eines Drehstromsynchronläufers, wird zur elektrischen Energieversorgung im Kraftfahrzeug in der Regel über den Keilriemen vom Verbrennungsmotor angetrieben und ist auf diese Weise starken Drehzahlschwankungen unterworfen. Daher sollte auch die Geräuschprüfung über einen entsprechenden Drehzahlbereich erfolgen. Dazu wird der Generator auf einem Prüfstand angeordnet. Um am Generator die gewünschten Drehzahlen einstellen zu können, ist ein zusätzlicher leistungsstarker Antrieb notwendig, der beispielsweise über einen Riemenantrieb angekoppelt wird. Für die Erzielung von neutralen Meßbedingungen sollte der Aufbau in einer Geräuschmeßzelle erfolgen, wobei überdies darauf zu achten ist, daß die Laufgeräusche des zusätzlichen Antriebs die Bewertung der Betriebsgeräusche des Generators nicht nachteilig beeinflussen.

Die Bewertung des Generators bei der jeweiligen Drehzahl kann nach einer subjektiven Methode von einer Anzahl Testpersonen vorgenommen werden. Die subjektive Beurteilung ist selbstverständlich immer mit Ungenauigkeiten behaftet. Bei einer anderen Vorgehensweise wird über Mikrofone die Größe der Amplituden der abgestrahlten Schwingungen im Luftschall aufgenommen. Hierdurch erhält man eine gute Reproduzierbarkeit der Messung und objektive Vergleichskurven zu anderen Messungen.

Bei bestimmten Drehzahlen nimmt die Lautstärke des Geräusches aufgrund von Resonanzbedingungen stark zu. Das Anfahren dieser Resonanzstellen ist allerdings mit dem oben beschriebenen Aufbau, d. h. mit der zusätzlichen leistungsstarken Antriebseinheit, nicht immer in exakter Weise möglich. Dies liegt daran, daß aufgrund der Lastschwankungen bei einer Umdrehung des Generators die Drehzahl ebenfalls innerhalb der Umdrehung schwankt und somit eine bestimmte Drehzahl nicht mit ausreichender Genauigkeit eingestellt werden kann.

Die Erfindung hat die Aufgabe, eine Vorrichtung zur Bewertung der Geräusche von elektrischen Maschinen oder Geräten mit wenigstens einer Spulenwicklung, bereitzustellen, bei der ein geringerer Konstruktionsaufwand notwendig und die Genauigkeit der Bewertung verbessert ist. Weiterhin soll ein Verfahren zur Bewertung der Geräusche aufgezeigt werden, das im Vergleich zum Stand der Technik ebenfalls einfacher und genauer ist. Das Verfahren soll sich für die Überwachung der Fertigung eignen.

### Vorteile der Erfindunq

Der Kerngedanke der Erfindung liegt darin, daß mittels einer elektrischen Erregung der Spulenwicklung das dadurch erzeugte magnetische Wechselfeld und die wiederum dadurch verursachten mechanischen Schwingungen ein Geräusch erzeugen. Mit diesem Geräusch läßt sich einerseits das im herkömmlichen Strom führenden Betriebszustand auftretende Geräusch nachbilden. Darüber hinaus gibt das vom magnetischen Wechselfeld hervorgerufene Geräusch Auskunft über die Einhaltung von Funktionsparametern des stromdurchflossenen Bauteils oder über die Einhaltung von bestimmten Fertigungsparameter, nach denen das stromdurchflossenen Bauteil hergestellt wurde. Damit ist es möglich, die erfindungsgemäße Vorrichtung und das erfindungsgemäße Verfahren zur Fertigungskontrolle bzw. zur Qualitätsprüfung von stromdurchflossenen Bauteilen einzuetzen. Die elektrische Maschine bzw. das elektrische Gerät muß zur Qualitätsprüfung nicht im fertig montierten Zustand vorliegen.

Bezogen auf die Geräuschprüfung von Generatoren ist kein leistungsstarker Antrieb notwendig, der diesen auf die Drehzahl bringt, für die eine Bewertung durchgeführt werden soll. Statt dessen wird beispielsweise die Ständerwicklunq des Generators mit einer Wechselspannung beaufschlagt, deren Frequenz der zu bewertenden Drehzahl entspricht. Überraschenderweise stellen sich dadurch am Generator Betriebsgeräusche ein, die im wesentlichen denen entsprechen, als wenn der Rotor des Generators auf der der Frequenz entsprechenden Drehzahl laufen würde. Dies begründet sich vor allem darin, daß bei herkömmlichen elektrischen Maschinen, die Betriebsgeräusche im wesentlichen durch die Wechselwirkungen der magnetischen Kräfte in der Maschine zustandekommen. Eine Abweichung von einer Messung bei tatsächlicher Rotation kann allerdings auftreten, wenn andere Geräuschquellen, wie beispielsweise Lagergeräusche, Streifergeräusche, Riemenantriebsgeräusche oder dergleichen dominant werden. Durch eine derartige Bewertung ist es somit außerdem möglich, die durch das Magnetfeld hervorgerufenen Geräusche von sonstigen Geräuschquellen eindeutig zu trennen. Die vom magnetischen Wechselfeld erzeugten Geräusche können in vielfältiger Weise detektiert bzw. weiterverarbeitet werden. Bei mehrspuligen elektrischen Maschinen kann eine mehrphasige Speisung vorteilhaft sein, bei der ggf. Wellenform und/oder Phasenlage der Wechselspannung frei einstellbar sind. Auf diese Weise gewinnt man bei der Analyse der Betriebsgeräusche weitere Freiheitsgrade.

Um die Bewertung über einen bestimsten Frequenzbereich, also Drehzahlbereich, durchführen zu können, wird desweiteren vorgeschlagen, daß die Wechselspannungsquelle in ihrer Frequenz variabel ist.

Zur rechnergesteuerten Durchführung der Messung wird weiterhin vorgeschlagen, daß die Frequenz der Wechselspannungsquelle automatisch einstellbar ist.

Außerdem ist es besonders bevorzugt, wenn bei Generatoren Antriebsmittel für eine Drehbewegung des Läufers während der Bestromung vorgesehen sind. Bei elektrischen Maschinen ist die magnetische Kopplung nicht völlig unabhängig von der Stellung des Läufers im Vergleich zum Ständer. Durch eine Drehung des Läufers, die sehr langsam sein kann, (beispielsweise 140 Umdrehungen pro Minute) werden derartige Unsymmetrien ausgemittelt. Dabei ist es im Weiteren vorteilhaft, eine variable Drehzahl des Rotors zu ermöglichen.

Um in vergleichsweise einfacher Weise eine Drehbewegung des Läufers realisieren zu können, wird außerdem vorgeschlagen, daß die Antriebsmittel einen vorzugsweise leisen Getriebemotor umfassen.

Zur rationellen Verarbeitung von detektierten Geräuschen wird weiterhin vorgeschlagen, daß die Mittel zur Verarbeitung einen elektronischen Rechner beinhalten.

Außerdem ist es besonders vorteilhaft, wenn die Aufnahmeeinrichtung wenigstens ein Mikrofon zur Detektion des Schalldrucks umfaßt. Hiermit wird eine besonders gängige Methode zur Geräuschmessung verwirklicht.

Ebenso ist es in einer vorteilhaften Ausführungsform bevorzugt, wenn die Aufnahmeeinrichtung wenigstens einen Sensor zur Detektion von Körperschall beinhaltet. Auf diese Weise kann eine im Vergleich zur Schalldruckmessung feinfühligere Meßwerterfassung möglich werden.

Die Vorrichtung und das Verfahren lassen sich analog einsetzen zur Prüfung anderer Bauteile, wie z.B. von piezoelektrischen Bauteilen. Wichtig für die Ausnutzung der Erfindung ist, daß eine elektrische Erregung einer mechanischen Schwingung des Bauteils vorliegt.

### Ausführungsbeispiele

Ein erstes Ausführungsbeispiel der Erfindung ist in den Zeichnungen dargestellt und wird anhand der nachfolgenden Beschreibung näher erläutert. Ein zweites Ausführungsbeispiel wird anhand eines Verfahren zur Überprüfung der Fertigungsqualität eines stromdurchflossenen Bauteils beschrieben.

Im einzelnen zeigen:
Fig. 1a und b das schematische Schaltbild eines Dreiphasengenerators mit erfindungsgemäßer
   Wechselspannungsbestromung (a) bzw.
   gleichspannungsversorgtem Rotor (b),
Fig. 2 einen Generator in den Prüfstand einer Geräuschmeßzelle eingespannt in der schematischen Seitenansicht,
Fig. 3 den Prüfstand mit Generator aus Fig. 2 in der schematischen Draufsicht,
Fig. 4 die Verläufe der durch ein Mikrofon aufgenommenen Schalldruckpegel des Betriebsgeräusches eines Generators für das erfindungsgemäße Verfahren zur Bewertung und für ein herkömmliches Verfahren,
Fig. 5 den zeitlichen Verlauf der Schalldruckpegel des Betriebsgeräusches zweier Generatoren bei einer konstanten Erregerfrequenz (Drehzahl).

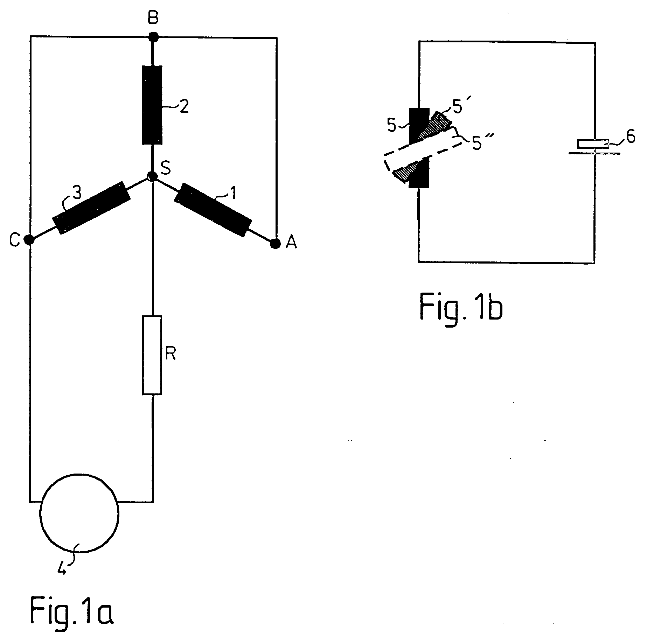

In Fig. 1a und b ist ein schematisches Schaltbild einer Lichtmaschine für ein Kraftfahrzeug, z. B. eines zwölfpoligen Drehstromsynchronläufers, dargestellt. Im folgenden soll der Begriff Stator anstatt Ständer verwendet werden, da es sich um eine Synchronmaschine handelt. Der sich drehende Teil wird als Rotor oder Läufer bezeichnet. Entsprechend Fig. 1a werden die Statorwicklungen 1, 2, 3 über die Anschlüsse A, B, C sowie den Sternpunkt S und einen Vorwiderstand R erfindungsgemäß mit einer Wechselspannungsquelle 4 verbunden. Der Rotor 5 (Fig. 1b) kann zur Ausbildung eines magnetischen Rotorfelds aus einer Gleichspannungsquelle 6 versorgt werden. Eine mögliche Drehbewegung des Rotors soll durch die gestrichelt eingezeichneten Rotorpositionen 5' bzw. 5'' anqedeutet werden.

Die Wechselspannungsquelle 4 läßt sich beispielsweise in der Frequenz und in der Amplitude einstellen. Eine durch die Quelle 4 angelegte Wechselspannung erzeugt in den Statorwicklungen 1 bis 3 ein magnetisches Wechselfeld. Hierdurch wird der Stator in mechanische Schwingungen versetzt, die im wesentlichen das Betriebsgeräusch verursachen. In der Regel wird der Stator auf bestimmte Frequenzen "empfindlicher" reagieren, d. h. es wird sich eine besonders starke Schwingung ausprägen. In Abhängigkeit davon, wie der Stator in seiner Umgebung angeordnet ist, wird das Betriebsgeräusch leiser oder lauter sein. Die Anordnung oder Ankopplung des Stators in seinem Umfeld kann beispielsweise in einem theoretischen Modell durch eine Übertragungsfunktion erfaßt werden.

Um den tatsächlichen Betriebsfall nachzuempfinden, wird der Rotor mit einer üblichen Gleichspannung beaufschlagt (bei einem permanentmagnetischen Rotor entfällt dies selbstverständlich). Hierdurch ändert sich die magnetische Kopplung im Generator und damit auch das von diesem abgegebene Geräusch. Wie sich bei Versuchen herausgestellt hat, wird das Betriebsgeräusch lauter, da sich der Stator über die magnetischen Kräfte am Rotor "abstützen" kann, wodurch sich die Amplitude der Statorschwingung vergrößert. Wie weiter unten noch detaillierter beschrieben werden wird, hat zusätzlich die Winkelstellung des Rotors in bezug auf den Stator einen Einfluß auf die am Generator auftretenden Schwingungen und damit auf die Geräuschbildung. Dies liegt in erster Linie daran, daß sich die magnetische Kopplung zwischen Stator und Rotor durch das Aufeinandertreffen von daran angebrachten Klauen bzw. Zähnen während der Rotation des Rotors kontinuierlich verändert.

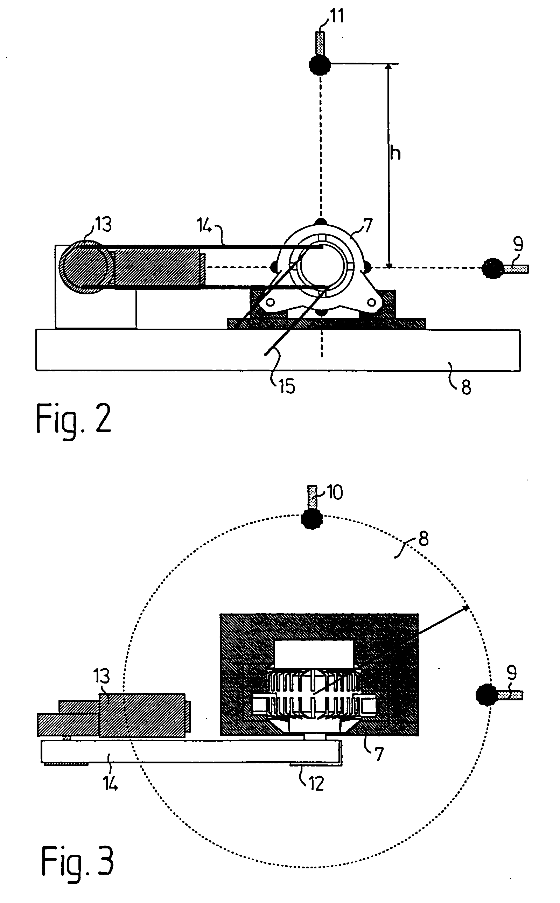

Zweckmäßigerweise wird zur Bewertung der Betriebsgeräusche ein Amplitudenspektrum aufgenommen, bei dem beispielsweise mittels eines oder mehreren Mikrofone der Schalldruckpegel in der Umgebung des Generators in einen bestimmten Frequenzbereich gemessen wird. Eine derartige Messung kann in einer Geräuschmeßzelle durchgeführt werden, die einen Prüfstand entsprechend der Fig. 2 und 3 besitzt. Hierzu wird ein Generator 7 (beispielsweise 12poliger Drehstromsynchronläufer) auf einen Montagetisch 8 aufgespannt. Die Geräuschmeßzelle, die Störgeräusche und Reflektionen ausschließen soll, verfügt im Ausführungsbeispiel über drei Mikrofone 9, 10, 11. Die Mikrofone 9 und 10 sind in einer Ebene parallel zum Montagetisch auf einer Kreislinie mit einem Radius von ungefähr r = 30 cm um das Zentrum des Generators 7 angeordnet. Das dritte Mikrofon 11 ist in einer Höhe h von beispielsweise 50 cm senkrecht zur Tischebene über dem Zentrum des Generators positioniert. Als Zentrum kann die Mitte des Rotors auf seiner Drehachse 12 festgelegt werden. Um eine langsame Drehbewegung des Rotors (beispielsweise 1 bis 200 Umdrehungen pro Minute) realisieren zu können, ist ein leiser Getriebemotor 13 angeordnet, der über einen Antriebsriemen 14 die Drehachse 12 des Rotors 5 antreibt. Erfindungsgemäß kann auf einen leistungsstarken Antrieb, mit dem bei einer herkömmlichen Bewertung der Rotor des Generators auf Drehzahlen von mehreren tausend Umdrehungen pro Minute gebracht wird, ganz verzichtet werden. Ein dazu notwendiger entsprechend dimensionierter Antriebsriemen 15 ist in Fig. 2 zum besseren Verständnis dennoch angedeutet. Damit entfallen auch Maßnahmen, die bei einem leistungsstarken Motor getroffen werden müssen, um diesen akustisch von der Meßvorrichtung zu trennen. Das bei der herkömmlichen Bewertung aufgrund der hohen Drehzahl des Rotors sich einstellende magnetische Wechselfeld und die damit verbundenen Betriebsgeräusche lassen sich, um dies nochmal deutlich zum Ausdruck zu bringen, erfindungsgemäß durch das Anlegen einer Wechselspannung, deren Frequenz der Drehzahl des Rotors entspricht, nachempfinden. Somit ist der zusätzliche leistungsstarke Antrieb überflüssig, wodurch sich die Vorrichtung zur Bewertung der Betriebsgeräusche erheblich vereinfacht.

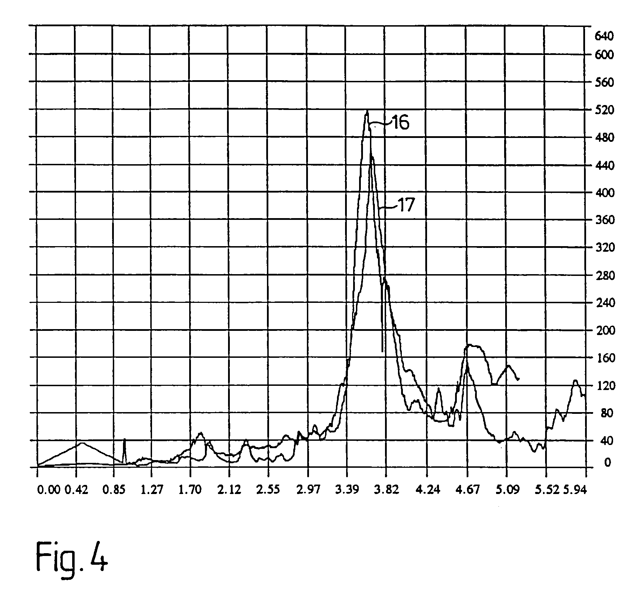

Die gute Korrelation eines herkömmlich aufgenommenen Amplitudenspektrums 16 und eines erfindungsgemäß gewonnen Amplitudenspektrums 17 soll in dem Schaubild von Fig. 4 verdeutlicht werden. Beide Meßkurven wurden beispielsweise über das Mikrofon 9 aufgenommen, wobei auf der Ordinate die Amplitude des Schalldrucks in mPa (Millipascal) und auf der Abszisse die Frequenz bzw. Drehzahl in kHz (Kilohertz) aufgetragen ist. Die Hauptresonanzstelle tritt für beide Meßverfahren nahezu an der gleichen Stelle auf, wobei überdies die Amplituden nahezu deckungsgleich sind. Erst ab ungefähr 4.5 kHz fällt die erfindungsgemäß aufgenommene Kurve stark ab, da der nur sehr langsam sich drehende Rotor (beispielsweise 140 Umdrehungen pro Minute) die im herkömmlichen Fall mit größerer Drehzahl anwachsenden Geräusche eines Lüfters bzw. des Antriebsriemens nicht abstrahlen kann. Der Meßbereich unter einem kHz ist nicht von großer Bedeutung, da diese Drehzahl in einem Fahrzeug nicht auftritt.

Zur Aufnahme der Betriebsgeräusche sind unterschiedliche Mikrofonpositionen möglich, wobei es sich herausgestellt hat, daß eine Positionierung des Mikrofons im Bereich des Mikrofons 9 besonders geeignete Meßwerte liefert.

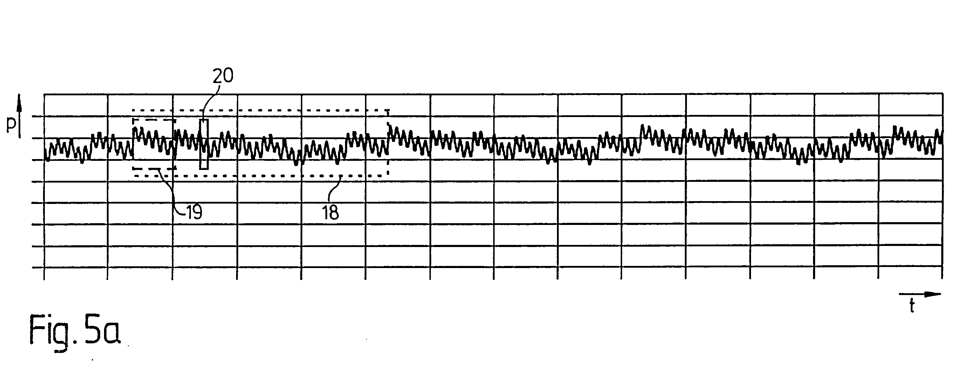

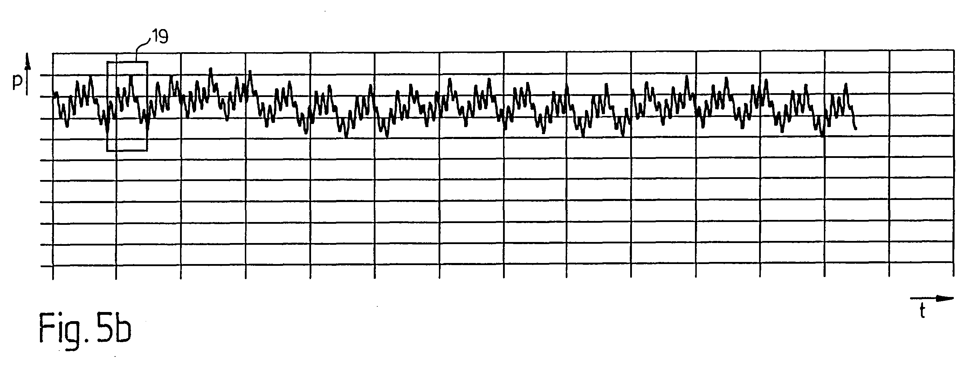

Bei der Aufnahme des erfindungsgemäßen Amplitudenspektrums 17 gemäß Fig. 4, hat sich, wie bereits erwähnt, der Rotor mit einer geringen Umdrehungszahl von ungefähr 140 Umdrehungen pro Minute gedreht. Wird diese Drehzahl weiter erniedrigt, auf beispielsweise wenige Umdrehungen pro Minute, kann im zeitlichen Verlauf eines Mikrofonsignals für eine bestimmte angelegte Wechselspannungsfrequenz der Einfluß der Rotor bzw. Statorgeometrie sichtbar gemacht werden (siehe Fig. 5a und b). In Fig. 5a entspricht der große gestrichelte Kasten 18 einer Umdrehung. Der kleinere gestrichelte Kasten 19 entspricht dem Weiterdrehen des Rotors um ein Polpaar. Schließlich umfaßt der kleinste durchgezogene Kasten 20 das Weiterdrehen des Rotors um eine Nutung auf einem Polpaar. Deutlich ist jede Nutung im Kurvenverlauf sowohl in Fig. 5b als auch in Fig. 5a zu sehen. Dabei ist der Kurvenverlauf in Fig. 5b für einen lauten Generator und der in Fig. 5a für einen leisen Generator stellvertretend. Vergleicht man den Verlauf des Schalldruckpegels p für ein Polpaar, so ist für den lauten Generator eine ansteigende Tendenz des Schalldruckpegels feststellbar, wohingegen beim leisen Generator eine abfallende Tendenz vorhanden ist (vergleiche die gestrichelten Kasten 19 in Fig. 5a und 5b). Das erfindungsgemäße Bewertungsverfahren gibt somit zusätzlich Aufschlüsse über das Zusammenspiel von Rotor und Stator in einem Generator. Gegebenenfalls lassen sich auch Aussagen über Ungleichmäßigkeiten im magnetischen Feld in Bezug auf den Drehwinkel des Rotors oder einen unrund laufenden Rotor machen.

Mit Hilfe der erindungsgemäßen Vorrichtung bzw. des erfindungsgemäßen Verfahrens zur Bewertung der Betriebsgeräusche lassen sich die Amplitudenspektren unterschiedlicher Generatoren in einfacher Weise aufnehmen und zu ihrer Analyse miteinander vergleichen. Dabei schließt das erfindungsgemäße Verfahren und die Vorrichtung auch die Bewertung an vorher erwärmten Generatoren nicht aus. Dies kann sinnvoll sein, da im Betriebsfall beispielsweise in einem Kraftfahrzeug) die Generatoren eine typische Temperatur von 160° C und Maximalwerte bis 200° C erreichen. Bei diesen Temperaturen ändert sich das mechanische und magnetische Verhalten der für den Generator verwendeten Materialien, vor allem das von Kunstharz, in dem Wicklungen eingebettet sind. Die Erwärmung in der Vorrichtung kann beispielsweise auf ohmschem Wege durch einen erhöhten Stromfluß in den Spulenwicklungen erfolgen. Daran anschließend können die Amplitudenspektren erfindungsgemäß aufgenommen werden.

Aufgrund der Einfachheit des Verfahrens und der Vorrichtung kann eine Anwendung nicht nur für die Produktentwicklung, sondern auch in der Serienproduktion bzw. Fertigung sinnvoll sein.

Weiterhin läßt sich die Vorrichtung und das Verfahren zur Fertigungskontrolle bzw. Qualitätsprüfung von stromdurchflossenen elektrischen Bauteilen einsetzen. Diese Anwendung des erfindungsgemäßen Verfahrens nutzt den Einfluß der Schwingungsdämpfung auf die Geräuschbildung. So kann mit dem beschriebenen Verfahren beispielsweise die Einhaltung einer bestimmten Schichtdicke an stromdurchflossenen Bauteilen überprüft werden, denn die Schichtdicke wirkt sich schwingungsdämpfend auf das Schallsprektrum der mechanischen Schwingung aus.

Als Beispiel sei die Prüfung der Schichtdicke eines mit Isolierlack überzogenen Drahtes einer Spulenwicklung genannt. Nach dem Beschichten des Drahtes, beispielsweise durch Eintauchen in ein Lack-Bad, wird an die Spulenwicklung eine Wechselspannung angelegt. Anhand des durch die elektrische Erregung erzeugten Geräusches wird auf die Schichtdicke der Isolierung geschlossen. Dazu wird vorher das Geräusch eines Drahtes mit einer Sollschichtdicke als Standardschallsprektrum aufgenommen. Das Standardschallspektrum wird dann mit dem aufgenommenen Schallspektrum der geprüften Spulenwicklung verglichen. Weicht das Schallspektrum der geprüften Spulenwicklung vom Standardschallspektrum ab, liegt nicht die erforderliche Schichtdicke vor. Dieser Fehler würde, abgesehen von einer eventuellen Sichtprüfung, erst im montierten Zustand entdeckt, wenn eine Prüfung der komplett montierten elektrischen Maschine vorgenommen wird.

Ein weiteres Anwendungsgebiet ist beispielsweise die Güteprüfung von Silikondämpfern zur Schwingungsabsorption an elektrischen Motoren.

Die Vorrichtung zur Durchführung des Verfahrens zur Fertigungskontrolle bzw. Qualitätsprüfung entspricht der in den Figuren 1 bis 3 beschriebenen Anordnung, wobei anstelle des Generators eine oder mehrere Spulen des stromdurchflossenen Bauteils angeordnet werden.

## Patentansprüche

1. Vorrichtung zur Bewertung der Geräusche von elektrischen Maschinen oder Geräten und/oder deren stromdurchflossener Bauteile, mit wenigstens einer Spulenwicklung, in der ein magnetisches Wechselfeld auftritt, mit einer Aufnahmeeinrichtung (9, 10, 11) zur Detektion der Geräusche und mit Mitteln zur Verarbeitung der Signale der Aufnahmeeinrichtung, **dadurch gekennzeichnet,** daß wenigstens eine Wechselspannungsquelle (4) für die Bestromung der wenigstens einen Spulenwicklung (1, 2, 3) der elektrischen Maschine oder des elektrischen Gerätes oder des stromdurchflossenen Bauteils zur Erzeugung einer mechanischen Schwingung vorgesehen ist, mit der das Geräusch ausbildbar ist.

2. Vorrichtung nach Anspruch 1, dadurch gekennzeichnet, daß mit der Frequenz der Wechselspanßung das Geräusch im herkömmlichen stromführenden Betriebszustand nachbildbar ist.

3. Vorrichtung nach Anspruch 2, dadurch gekennzeichnet, daß die Wechselspannungsquelle (4) in der Frequenz variabel ist.

4. Vorrichtung nach Anspruch 2 oder 3, dadurch gekennzeichnet, daß die Frequenz der Wechselspannungsquelle (4) automatisch einstellbar ist.

5. Vorrichtung nach Anspruch 1, dadurch gekennzeichnet, daß Antriebsmittel für eine Drehbewegung eines Läufers der elektrischen Maschine während der Bestromung vorgesehen sind.

6. Vorrichtung nach Anspruch 5, dadurch gekennzeichnet, daß die Antriebsmittel einen Getriebemotor (13) umfassen, dessen Drehzahl einstellbar ist.

7. Vorrichtung nach Anspruch 1, dadurch gekennzeichnet, daß die Mittel zur Verarbeitung der Signale einen elektronischen Rechner beinhalten.

8. Vorrichtung nach Anspruch 1, dadurch gekennzeichnet, daß die Aufnahmeeinrichtung wenigstens ein Mikrofon (9, 10, 11) zur Detektion des Schalldrucks umfaßt.

9. Vorrichtung nach Anspruch 1, dadurch gekennzeichnet, daß die Aufnahmeeinrichtung wenigstens einen Sensor zur Detektion von Körperschall beinhaltet.

10. Verfahren zur Bewertung der Geräusche von elektrischen Maschinen oder Geräten und/oder deren stromdurchflossener Bauteile, mit wenigstens einer Spulenwicklung, in der ein magnetisches Wechselfeld auftritt, wobei die Geräusche aufgenommen und die aufgenommenen Signale verarbeitet werden, **dadurch gekennzeichnet,** daß die Spulenwicklung zur Ausbildung des magnetischen Wechselfeldes mit einer Wechselspannung beaufschlagt wird und daß die durch das magnetischen Wechselfeld verursachte mechanische Schwingung ein Geräusch erzeugt, das von der Aufnahmeeinrichtung aufgenommen wird.

11. Verfahren nach Anspruch 10, dadurch gekennzeichnet, daß mit der Frequenz der Wechelspannung das Geräusch im herkömmlichen stromführenden Betriebszustand nachgebildet wird.

12. Verfahren nach Anspruch 11, dadurch gekennzeichnet, daß die Messung der Geräusche bei unterschiedlichen Frequenzen durchgeführt wird.

13. Verfahren nach Anspruch 10, dadurch gekennzeichnet, daß zur Messung der Geräusche die Größe der Amplitude der abgestrahlten Schwingung im Luftschall aufgenommen wird.

14. Verwendung des Verfahrens nach Anspruch 10 zur Fertigungskontrolle und/oder Qualitätsprüfung von stromdurchflossenen Bauteilen, wobei das bei einer vorher festgelegten Frequenz der Wechselspannung auftretende Geräusch bewertet wird, derart, daß das Schallspektrums des aufgenommenen Geräusches mit einem vorher festgelegten Standardschallspektrum, das dem Geräusch des Sollzustands entspricht, verglichen wird.
